(19) Europäisches Patentamt
European Patent Office
Office européen des brevets

(11) Veröffentlichungsnummer: **0 011 738 B1**

(12) # EUROPÄISCHE PATENTSCHRIFT

(45) Veröffentlichungstag der Patentschrift: **20.10.82**

(51) Int. Cl.³: **C 04 B 41/06**

(21) Anmeldenummer: **79104341.7**

(22) Anmeldetag: **06.11.79**

(54) **Verfahren zur Herabsetzung der Porosität und der Oberflächenrauhigkeit einer keramischen Unterlage und Beschichtungsmasse dafür.**

(30) Priorität: **04.12.78 US 966188**

(43) Veröffentlichungstag der Anmeldung: **11.06.80 Patentblatt 80/12**

(45) Bekanntmachung des Hinweises auf die Patenterteilung: **20.10.82 Patentblatt 82/42**

(84) Benannte Vertragsstaaten: **DE FR GB**

(56) Entgegenhaltungen:
DE-A-2 451 850
DE-B-2 053 110
US-A-3 055 776
US-A-3 086 892
US-A-3 243 314

(73) Patentinhaber: **International Business Machines Corporation, Armonk, N.Y. 10504 (US)**

(72) Erfinder: **Bakos, Peter, 530A Reuben Drive, Endicott New York 13760 (US)**

(74) Vertreter: **Kreidler, Eva-Maria, Dr. rer. nat., Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

EP 0 011 738 B1

# Verfahren zur Herabsetzung der Porosität und der Oberflächenrauhigkeit einer keramischen Unterlage und Beschichtungsmasse dafür

Die Erfindung betrifft ein Verfahren zur Herabsetzung der Porosität und der Oberflächenrauhigkeit einer keramischen Unterlage und eine Beschichtungszusammensetzung zur Durchführung des Verfahrens sowie die Verwendung dieser Beschichtungszusammensetzung zur Beschichtung von Unterlagen für metallische Schaltkreise.

Keramikunterlagen werden in grossem Umfang zur Herstellung integrierter Schaltkreismoduln verwendet. Es ist bekannt, dass die Ergebnisse, die beim Ätzen eines metallischen Überzugs auf einer keramischen Unterlage erhalten werden, in hohem Masse von der Rauhigkeit dieser Unterlage beeinlusst werden. Wegen der sich ändernden Eigenschaften einer rauhen keramischen Oberfläche im Hinblick auf Korngrösse, Porosität, Kristallinität und Glasphase werden beim Ätzen oft schlechte Ergebnisse erhalten. Diese Probleme treten besonders dann auf, wenn feine Linien oder Schaltkreise hoher Auflösung geätzt werden sollen. Obgleich keramische Unterlagen mit hoher Oberflächenglätte im Handel erhältlich sind, sind diese relativ teuer.

Eine Lösung der Herstellung eines billigen Moduls als Träger für Schaltkreise hoher Auflösung ist, die Keramikunterlage mit einem Überzug aus Polyimid zu beschichten. Die Verwendung von Polyimid zu diesem Zweck wird im IBM Technical Disclosure Bulletin, Volume 20, Nr. 8, Januar 1978, Seite 3020 beschrieben. Die Verwendung von Polyimidüberzügen für diesen Zweck ist jedoch nicht völlig zufriedenstellend, weil das Polyimid, wenn die Moduln hohen Temperaturen ausgesetzt werden, abgebaut wird und in bestimmten Fällen müssen die Moduln während nachfolgender Prozessschritte hohen Temperaturen (etwa 300 bis 700°C) ausgesetzt werden. Wenn beispielsweise Cermet-Widerstandselemente auf dem Modul angebracht werden sollen, muss dieser während des Aufbringens auf hohe Temperaturen erhitzt werden.

Um alle zuvor angegebenen Forderungen zu erfüllen, müssen die verwendeten Zusammensetzungen eine Reihe wichtiger Eigenschaften aufweisen. Beispielsweise müssen die Zusammensetzungen die Oberflächenglätte einer Keramikunterlage verbessern und gleichzeitig widerstandsfähig gegen hohe Temperaturen, die in nachfolgenden Prozessschritten angewendet werden, sein. Die Zusammensetzungen müssen darüber hinaus billig sein, damit sie die Kosten für Keramikmaterialien mit glatten Oberflächen, die im Handel erhältlich sind, nicht überschreiten. Weiterhin müssen die angewendeten Materialien elektrisch isolierend sein, damit sie, wenn sie mit der Unterlage verbunden sind, die nachfolgend aufgebrachten Schaltkreise nicht nachteilig beeinflussen, und sie müssen eine glatte Oberfläche erzeugen. Das Material muss auch auf der Keramikunterlage fest haften und eine ausreichende Haftung bezüglich der nachfolgend aufgebrachten Überzüge, beispielsweise metallischer Überzüge besitzen. Es ist auch erforderlich, dass die Zusammensetzungen eine ausreichende Fliesscharakteristik aufweisen, damit sie in die verschiedenen Poren und Spalten der Unterlage eindringen, um die Porosität und Oberflächenrauhigkeit der Unterlage zu verbessern. Die angewendete Überzugszusammensetzung muss auch während der nachfolgenden Behandlung der keramischen Unterlagen in den Poren und Spalten verbleiben. Es ist sehr schwierig, eine Zusammensetzung bereitzustellen, die alle die zuvor genannten Eigenschaften in ausreichendem Masse aufweist.

Aufgabe der Erfindung ist deshalb ein Verfahren zur Herabsetzung der Porosität und Oberflächenrauhigkeit einer keramischen Unterlage, bei dem die zuvor angegebenen Nachteile keramischer Unterlagen nicht auftreten. Aufgabe der Erfindung ist auch die Bereitstellung einer Beschichtungslösung zur Anwendung in diesem Verfahren.

Die Aufgabe der Erfindung wird durch ein Verfahren gemäss Patentanspruch 1 gelöst. Vorteilhafte Ausgestaltungen der Erfinfung sind in den Unteransprüchen niedergelegt.

Die durch die Erfindung erreichten Vorteile sind darin zu sehen, dass keramische Unterlagen mit niedriger Porosität und Oberflächenrauhigkeit hergestellt werden können. Die in dem erfinfungsgemässen Verfahren verwendeten Materialien sind sehr billig und führen zu Überzügen, die sowohl auf der Unterlage haften wie auch eine gute Adhäsion zu den nachfolgend aufgebrachten Metalüberzügen aufweisen. Besonders hervorzuheben ist, dass die nach dem erfindungsgemässen Verfahren aufgebrachten Überzüge besonders widerstandsfähig gegen nachfolgend angewendete hohe Temperaturen sind.

Gengenstand der vorliegenden Erfindung ist ein Verfahren zur Herabsetzung der Porosität und der Oberflächenrauhigkeit einer keramischen Unterlage. Das Verfahren umfasst das Auftragen einer flüssigen Beschichtungsmasse, welche wenigstens eine nichtpolymere gesättigte organische Siliciuverbindung und wenigstens eine nichtpolymere äthylenisch ungesättigte organische Siliciumverbindung enthält, auf wenigstens eine Oberfläche der keramischen Unterlage. Die Unterlage wird dann getrocknet und einer erhöhten Temperatur ausgesetzt oder unterworfen, welche höher als die bei der Trocknung angewendete Temperatur ist. Dadurch werden die Siliciumverbindungen, welche auf dem Substrat zurückbleiben, in Siliciumoxide überführt, und eine keramische Unterlage mit einer niedrigen Porosität und Oberflächenrauhigkeit wird erhalten.

Die vorliegende Erfindung betrifft auch Mischungen bevorzugter Organosiliciumverbindungen, welche 45 bis 95 Gew.% bestimmter gesättigter Organosilane und 5 bis 55 Gew.% bestimmter äthylenisch ungesättigter Organosilanverbindungen enthalten. Die Gew.% beziehen sich auf den Gesamtgehalt der Zusammensetzung an gesättigten und ungesättigten Organosilanverbindungen.

Die Unterlagen, die gemäss der Erfindung behandelt werden sollen, sind vorzugsweise keramische Unterlagen. Diese enthalten Siliciumoxide und Silicate wie Aluminiumsilicate und Aluminiumoxide. Die keramischen Unterlagen, welche durch das erfindungsgemässe Verfahren am meisten verbessert werden, sich solche, welche eine Oberflächenrauhigkeit von wenigstens 10 μm aufweisen. Es können natürlich auch Unterlagen mit einer niedrigeren Oberflächenrauhigkeit erfindungsgemäss behandelt werden. Die Oberflächenrauhigkeit wird ausgedrückt durch den Mittelwert der Mittellinie zwischen der Höhe einer Spitze und der Tiefe einer Vertiefung auf der Oberfläche der Unterlage. Die vorliegende Erfindung findet besonders Anwendung bei der Herstellung von Unterlagen für integrierte Schaltkreismoduln und insbesondere bei der Herstellung von Schaltkreisen mit hoher Auflösung.

Ein Überzug, welcher wenigstens eine gesättigte und eine äthylenisch ungesättigte organische Siliciumverbindung enthält, wird mindestens auf eine Oberfläche der keramischen Unterlage aufgetragen. Die verwendeten Siliciumverbindungen sind nichtpolymere Verbindungen. Die Verwendung polymerer Organosiliciumverbindungen ist für die Zwecke der vorliegenden Erfindung, d.h. für die Herstellung glatter Oberflächen nicht geeignet, weil diese Verbindungen bei dem Erhitzen, das in dem erfindungsgemässen Verfahren durchgeführt wird, in zu hohem Masse zur Karbonisierung auf der Oberfläche der Unterlage neigen. Die Verwendung von Polysiliciumverbindungen zur Imprägnierung von Ziegelsteinen, um diese weniger porös zu machen und ihre Widerstandsfähigkeit gegenüber geschmolzenem Glas zu verbessern, ist in der US-Patentschrift Nr. 3816163 beschrieben. Dort ist angegeben, dass die Polysiliciumverbindungen nach der Imprägnierung der Ziegelsteine einer thermischen Zersetzung zu Siliciumdioxid unterworfen werden. Die genannten Verbindungen sind jedoch, weil sie polymerer Natur sind, für einen der wesentlichen Zwecke der vorliegenden Erfindung, der Verbesserung der Oberflächenrauhigkeit, nicht geeignet wegen ihrer Tendenz zur Karbonisierung.

Andere Beispiele für die Anwendung polymerer oder harzartiger Siliciumverbindungen sind in den US-Patentschriften Nrn 4041190 und 3617341 beschrieben. In der US-Patentschrift Nr. 4041190 ist die Bildung eines Siliciumdioxidüberzugs beschrieben, wobei ein Polysiloxan einer Bestrahlung und anschliessend einer thermischen Behandlung ausgesetzt wird. In der US-Patentschrift Nr. 3617341 ist die Ausbildung eines Überzugs durch die Zersetzung einer Formulierung, welche ein Siliciumresinat enthalten kann, beschrieben.

Weiterhin ist es wesentlich, dass die Überzugszusammensetzung, die auf die keramische Unterlage aufgetragen wird, flüssig und fliessfähig ist, damit gewährleistet ist, dass die Siliciumverbindungen einwandfrei in die Poren, die Risse oder Vertiefungen der Unterlage fliessen. Die Verwendung von Organosiliciumverbindungen in Dampfform zur Beschichtung verschiedener Unterlagen wurde auch beschrieben, aber diese Art der Anwendung gestattet die vollständige Ausfüllung der Risse oder Unregelmässigkeiten auf der Unterlage, wie es erfindungsgemäss gefordet wird, nicht. Beispiele für die Abscheidung von Organosiliciumverbindungen aus der Dampfphase sind in den US-Patentschriften Nrn 3243314 und 3242007 beschrieben. In der US-Patentschrift Nr. 3243314 ist die Anwendung von Viynltriäthoxysilan für die thermische Zersetzung zu Siliciumdioxiden, welche eine passivierende Schicht auf einer Halbleitervorrichtung bilden, beschrieben. In der US-Patentschrift Nr. 3242007 ist die Ausbildung eines Schutzüberzugs auf einer Halbleitervorrichtung aus der Dampfphase beschrieben, wobei das angewendete Siloxan Vinyltriäthoxysilan sein kann.

Ein weiterer Vorteil der Anwendung der Zusammensetzung in flüssiger Form im Gegensatz zur Abscheidung aus der Dampfphase ist, dass die Dicke genau kontrolliert werden kann. Zusätzlich können sehr dünne Überzüge hergestellt werden, welche bereits vorhandene Öffnungen auf der keramischen Unterlage, die anschliessend für die Einführung von Stiften verwendet werden, nicht verstopfen.

Ein anderer Stand der Technik, welcher in diesem Zusammenhang von Interesse ist, ist die US-Patentschrift Nr. 3086892, auf die weiter unten noch eingegangen wird. Weiterer Stand der Technik, welcher in weiterem Sinn von Interesse ist, schliesst die US-Patentschriften Nrn 2859139, 3547680, 3720542, 3932691 und 3962004 ein. In diesen Patentschriften wird vorgeschlagen, flüssige Zusammensetzungen mit einem Gehalt an einem Siloxan oder Silicon, welches nachfolgend durch Anwendung von Hitze zersetzt wird, anzuwenden. Weiterhin können die US-Patentschriften Nrn 3055776, 3158495, 3523819, 3668004 und 4047977 im Hinblick auf die Zersetzung von Siliconen bei erhöhten Temperaturen von Interesse sein.

Beispiele geeigneter Beschichtungszusammensetzungen zur erfindungsgemässen Verwendung enthalten nichtpolymere gesättigte Organosiliciumverbindungen und nichtpolymere äthylenisch ungesättigte Organosiliciumverbindungen.

In der vorliegenden Erfindung wird die Verwendung flüssiger Organosiliciumverbindungen bevorzugt. Obgleich auch Siliciumhalogenide wie Trichlorsilan und Siliciumtetrachlorid verwendet werden können, werden diese nicht verwendet wegen des verhältnismässig hohen Anteils an Chlor, der in diesen Verbindungen vorhanden ist und der bei der Zersetzung zu einer Diffusion unerwünschter Mengen von Chlorgas in die Unterlage führen kann. Dadurch können Korrosions- und Zuverlässigkeitsprobleme bei intergrierten Schaltkreisen auftreten, bei denen so behandelte Unterlagen verwendet werden.

Gemäss der vorliegenden Erfindung wird wenigstens eine nichtpolymere äthylenisch ungesättigte Organosiliciumverbindung in der Beschichtungszusammensetzung verwendet. Die äthylenisch ungesättigten Verbindungen können mono-

äthylenisch ungesättigt sein oder mehr als eine äthylenisch ungesättigte Gruppe enthalten. Beschichtungszusammensetzungen zur erfindungsgemässen Verwendung enthalten wenigstens eine nichtpolymere gesättigte Organosiliciumverbindung und wenigstens eine nichtpolymere äthylenisch ungesättigte Organosiliciumverbindung. Wenn eine Mischung nichtpolymerer gesättigter und ungesättigter Organosiliciumverbindungen verwendet wird, enthalten diese Zusammensetzungen vorzugsweise 5 bis 55 Gew.% der nichtpolymeren äthylenisch ungesättigten Organosiliciumverbindung und 45 bis 95 Gew.% der nichtpolymeren gesättigten Organosiliciumverbindung. Die zuvor angegebenen relativen Prozentgehalte beziehen sich auf den Gesamtgehalt an nichtpolymeren äthylenisch ungesättigten und gesättigten Organosiliciumverbindungen in den Zusammensetzungen.

Die Verwendung nichtpolymerer äthylenisch ungesättigter Verbindungen wird erfindungsgemäss bevorzugt, weil diese Verbindungen bei dem zuerst durchgeführten Trocknen zu einer Gelbildung und bis zu einem gewissen Grad zu einer Vernetzung neigen, wodurch die Zusammensetzung in den Rissen in der Unterlage in einem ausreichenden Mass fest wird, so dass die Unterlagen gehandhabt und/oder nachfolgenden Behandlungen zugeführt werden können. Dieser Aspekt ist besonders wichtig, wenn die zu behandelnde Unterlage im wesentlichen nicht eben ist.

In der erfindungsgemässen Ausführungsform werden Mischungen nichtpolymerer gesättigter und ungesättigter Organosiliciumverbindungen verwendet. Die Gegenwart einer gesättigten Verbindung in der Zusammensetzung neben einer ungesättigten Organosiliciumverbindung bewirkt, dass die Tendenz der ungesättigten Verbindungen zur Polymerisation, verglichen mit der Verwendung ungesättigter Verbindungen allein, herabgesetzt wird. Demnach werden in Gegenwart von gesättigten Verbindungen Überzüge erhalten, welche nach dem Zersetzungsschritt einen geringeren Rückstand ergeben, als wenn ungesättigte Verbindungen allein verwendet wurden. Durch die Gegenwart gesättigter Verbindungen wird auch erreicht, dass das Endprodukt einen glänzenden Überzug aufweist und im Gegensatz dazu etwas pulverförmiges Material anfällt, wenn nur ungesättigte Organosilane verwendet werden. Darüber hinaus sind in vielen Fällen gesättigte Organosilane weniger toxisch und billiger als äthylenisch ungesättigte Silane.

Im allgemeinen sind nichtpolymere gesättigte Organosilane (Verbindungen, die keine nichtbenzoiden ungesättigten Strukturen enthalten) für die Durchführung des erfindungsgemässen Verfahrens geeignet. Sie können dargestellt werden durch die folgende allgemeine Formel:

$$R'_ySiX_{4-y}$$

in der $R'_y$ ein organischer Rest oder eine Mischung verschiedener organischer Reste wie Alkyl, Aryl, Alkaryl, Cycloalkyl, Aralkyl, Acyl, Alkoxy und Aryloxy ist. Diese Reste können unsubstituiert oder durch einen oder mehrere Substituenten wie Amino, Hydroxy, Epoxid oder Halogen substituiert sein. Beispiele einiger geeigneter Alkylgruppen sind diejenigen, welche bis zu etwa acht Kohlenstoffatome enthalten, wobei Methyl, Äthyl, Propyl, Hexyl und Octyl als Beispiele genannt sind. Beispiele einiger Cycloalkylgruppen sind Reste mit bis zu sechs Kohlenstoffatomen, beispielsweise Cyclohexyl, Cyclobutyl und Cyclopentyl. Beispiele einiger Arylreste schliessen Alkaryl und Aralkylreste ein, in denen der Arylrest bis zu zehn Kohlenstoffatome enthält. Als solche seien Phenyl, Methylphenyl, Benzyl und Phenyläthyl genannt. Die Alkoxyreste enthalten im allgemeinen bis zu acht Kohlenstoffatome, und als Beispiele werden Methoxy, Äthoxy und Propoxy genannt. Als Beispiel für ein Aryloxyrest wird Benzoxy genannt. Wenn R' ein Acylrest ist, der im allgemeinen bis zu etwa acht Kohlenstoffatome enthält, kann er Acetyl, Propionyl und Butyryl sein. Beispiele einiger aminosubstituierter Kohlenwasserstoffreste schliessen Aminopropyl und Aminoäthyl ein. Beispiele einiger hydroxysubstituierter Kohlenwasserstoffreste schliessen Hydroxyäthyl und Hydroxypropyl ein. Beispiele epoxidsubstituierter Kohlenwasserstoffreste schliessen 3,4-Epoxidcyclohexyl und glycidoxypropyl ein. Beispiele einiger halogensubstituierter Reste schliessen Pentachlorphenyl, 1-Brom-3-trichlorpropyl und Perfluoralkylreste wie γ-Trifluorpropyl und δ-Trifluor-γ-difluorbutyl ein. Wenn es gewünscht wird, können auch Mischungen organischer Reste verwendet werden. Y ist eine ganze Zahl von 1 bis 4. X bedeutet Wasserstoff oder Halogen, beispielsweise Chlor.

Beispiele einiger geeigneter nichtpolymerer gesättigter Organosilanverbindungen schliessen Äthyltriäthoxysilan, Amyltriäthoxysilan, Äthyltrichlorsilan, Amyltrichlorsilan, Phenyltrichlorsilan, Phenyltriäthoxysilan, Methyltrichlorsilan, Methyldichlorsilan, Dimethyldichlorsilan, Methyltriäthoxysilan, Dimethyldiäthoxysilan, β-(3,4-Epoxidcyclohexyl)äthyltrimethoxysilan, γ-Aminopropyltriäthoxysilan, N-bis (β-hydroxyäthyl)-γ-aminopropyltriäthoxysilan, N-β-(Aminoäthyl)-γ-aminopropyltrimethoxysilan und γ-Glycidoxypropyltrimethoxysilan ein.

Die nichtpolymeren äthylenisch ungesättigten Organosilanverbindungen, die zur Durchführung der vorliegenden Erfindung geeignet sind, können durch die folgende Formel dargestellt werden:

$$R^2_{4-(z+w)}R'_zSiX_w$$

in der z und w jeweils ganze Zahlen von 0 bis 3 darstellen, vorausgesetzt, dass die Summe von $z+w=3$ oder weniger ist. R' und X haben die zuvor angegebene Bedeutung. $R^2$ ist ein äthylenisch ungesättigter organischer Rest und kann monoäthylenisch oder polyäthylenisch ungesättigt sein. Beispiele einiger äthylenisch ungesättigter Reste schliessen Vinyl, Allyl, 3-Butenyl, Acryl, Methacryl, Oleyl und Linoleyl ein. Beispiele einiger äthylenisch ungesättigter Organosiliciumverbindungen schliessen Vinyltrichlorsilan, Vinyltriäthoxysilan, Vinyltriacetoxysilan, γ-Methacryloxypropyltrimethoxysilan, Methylvinyldichlorsilan und Vinyl-tris(2-methoxyäthoxy)silan ein.

Mischungen gesättiger Organosiliciumverbindungen und/oder Mischungen äthylenisch ungesättigter Organosiliciumverbindungen können, wenn es gewünscht wird, auch verwendet werden.

Die Siliciumverbindungen werden im allgemeinen in Verbindung mit einem Verdünnungsmittel angewendet, um die gewünschte Viskosität zu erhalten, die von der Anwendung der Zusammensetzung abhängt. Im allgemeinen enthalten die Zusammensetzungen etwa 25 bis etwa 90 Gew.% Verdünnungsmittel. Das Verdünnungsmittel sollte ein bei niedriger Temperatur verdampfendes Material sein, welches als Lösungsmittel für die Siliciumverbindung wirkt, aber im wesentlichen nicht mit der Siliciumverbindung und/oder mit der Keramikunterlage reagiert. Beispiele geeigneter organischer Verdünnungsmittel schliessen Alkohole wie Methanol, Äthanol, und Propanol; Ketone wie Aceton und Methyläthylketon und aromatische Verdünnungsmittel wie Benzol, Toluol und Xylol ein. Die Zusammensetzung kann durch Aufsprühen, durch Verspinnen oder durch ein Fliessbeschichtungsverfahren aufgetragen werden.

Die Zusammensetzungen können auch andere Bestandteile wie Stabilisatoren enthalten, welche die Lagerbeständigkeit der Zusammensetzungen verbessern. Ein bestimmter Stabilisator ist Piperidin. Er wird im allgemeinen in einer Menge von etwa 2,5 bis 7 Gew.% verwendet

Üblicherweise wird der Überzug in einem einstufigen Beschichtungsverfahren in einer Nassschichtdicke bis zu etwa 0,1 mm aufgetragen. Dies wird durchgeführt, um die Verkohlung des Materials während des nachfolgenden Erhitzens zu verhindern. Wenn es erforderlich ist, dickere Filme herzustellen, dann können Mehrfachbeschichtungsverfahren (zwei oder mehr Beschichtungsschritte) angewendet werden, nachdem die zuvor aufgetragende Beschichtung getrocknet und den entsprechenden Zersetzungschritten unterworfen wurde.

Nachdem die Zusammensetzung aufgetragen ist, wird sie einem ersten Erhitzen unterworfen. Die beschichtete Unterlage wird auf eine Temperatur unterhalb des Siedepunkts der Siliciumverbindung erhitzt, im allgemeinen auf eine Temperatur zwischen 50 und 200° C. Dieses Erhitzen wird so lange fortgeführt, bis alles organische inerte Verdünnungsmittel entfernt ist, was im allgemeinen 30 min bis 2 h in Anspruch nimmt.

Das beschichtete Substrat wird dann höheren Temperaturen ausgesetzt als beim ersten Erhitzen, um die Siliciumverbindungen in Siliciumoxide zu überführen. Die genaue Zusammensetzung des Siliciumoxidrückstands konnte nicht bestimmt werden; aber es ist wahrscheinlich, dass nicht eine einzige Substanz wie Siliciumdioxid, sondern eine Mischung aus Siliciumoxiden, welche Siliciumdioxid und Siliciummonoxid enthält, vorliegt. Im allgemeinen wird die Unterlage erhöhten Temperaturen von 500 bis 1700° C, vorzugsweise von 700 bis 1300° C unterworfen. Die Zeit für diese Hitzebehandlung liegt zwischen 2 und 6 h. Die Hitzebehandlungen können unter normalen atmosphärischen Bedingungen in Gegenwart von Luft oder in inerter Atmosphäre durchgeführt werden.

Die Zeiten und die Temperaturen der zuvor angegebenen Erhitzungsstufen sind zueinander invers. Wenn beispielsweise die Temperatur zunimmt, nimmt die Zeit bis zum Erhalt der gewünschten Ergebnisse ab.

Die Anwendung von wenigstens zwei Erhitzungsstufen ist wesentlich für die erfolgreiche Durchführung der Erfindung. Die Möglichkeit der Verunreinigung der Substratoberfläche zu einem nicht mehr annehmbaren Grad mit unerwünschtem Rückstand anders als Siliciumoxid wird im wesentlichen dadurch reduziert, dass zuerst das Verdünnungsmittel entfernt wird und dann die Siliciumverbindungen zersetzt werden. Bei Anwendung nur einer einmaligen Erhitzung findet eine Verkohlung in nicht mehr vertretbarem Masse statt. Durch das mehrstufige Erhitzen wurde bei der Zersetzung eher eine glänzende als eine pulverförmige Phase erhalten. Wenn darüber hinaus in den bevorzugten Ausführungsbeispielen eine nichtpolymere ungesättigte Organosiliciumverbindung verwendet wird, findet beim ersten Erhitzen bis zu einem gewissen Grad eine Gel-Bildung der ungesättigten Organosiliciumverbindung statt, welche ihrerseits dazu führt, dass die Siliciumverbindungen in ausreichendem Masse unbeweglich werden und so in den Poren und Spalten der Keramik haften bleiben.

Keramikunterlagen, die nach dem zuvor angegebenen Verfahren erhalten werden, weisen eine niedrige Porosität und eine herabgesetzte Oberflächenrauhigkeit zusammen mit einer glasartigen Oberfläche auf, die durch die Zersetzung der Siliciumverbindung erhalten wurde. Die Überzugszusammensetzung verbessert die Oberflächenrauhigkeit, indem Löcher und Fehlstellen in der Oberfläche ausgefüllt werden. Es wurde vorgeschlagen, entweder Halbleiterwafer oder ein Elektrodenkügelchen mit einer Lösung bestimmter Organosiliciumverbindungen zu beschichten, um bei der Herstellung von Halbleiterbauelementen vom Sperrschichttyp einen Rückstand von Siliciumoxiden, die an dem Kügelchen oder an der Waferoberfläche haften, zu bilden. Eine Vorrichtung dieser Art ist beispielsweise in der US-Patentschrift Nr. 3086892 beschrieben. Das Verfahren zur Herstellung des Halbleiterbauelements vom Sperrschichttyp, das in dieser Patentschrift beschrieben ist, führt nicht zu einer Verbesserung der Oberflächenunregelmässigkeiten der in diesem Verfahren verwendeten Unterlagen. Das Verfahren, das in dieser Patentschrift beschrieben ist, umfasst das Einlegieren des Kügelchens in den Wafer während der Zersetzung der Organosiliciumverbindung zu Siliciumoxiden. Die vorhandenen Siliciumoxide verhindern ein zu starkes Ausbreiten des Kügelchens auf der Waferoberfläche während des Legierens. Als Endprodukt wird

jedoch als Folge der Bedingungen während des Legierens eine wabenartige Struktur und keine im Hinblick auf die Oberflächenglätte verbesserte Oberfläche, wie erfindungsgemäss gefordert, erhalten.

Das erfindungsgemässe Verfahren findet, wie zuvor beschrieben, insbesondere Anwendung zur Herstellung von Keramikmoduln für integrierte Schaltkreise und dient im besonderen zum Grundieren oder Vorbereiten der Keramikoberflächen für die nachfolgende Metallabscheidung. Deshalb wird das Verfahren gemäss der Erfindung besonders dann angewendet, wenn die Keramikunterlage zur Herstellung von Schaltkreisen hoher Auflösung verwendet und anschliessend mit Metall oder mit Metallen beschichtet wird. In einer Ausführungsform wird beispielsweise eine Chrom-Kupfer-Chrom-Metallisierung aufgetragen. Das Metallisierungsmuster kann unter Anwendung konventioneller Verfahren hergestellt werden, und es werden Schaltkreise mit hoher Auflösung erhalten.

Die vorliegende Erfindung ist besonders zur Herstellung von Keramikunterlagen für integrierte Schaltkreise geeignet, weil die Produkte, die auf der Unterlage zurückbleiben (Siliciumoxide) elektrisch isolierende Eigenschaften aufweisen und gute thermische Leiter sind. Die Eigenschaften der guten Ableitung von Hitze sind nicht vorhanden, wenn beispielsweise Polyimide verwendet werden.

*Beispiel 1:*

Eine Zusammensetzung, die etwa 1,8 g β-(3,4-Epoxidcyclohexyl)äthyltrimethoxysilan, 0,6 g Vinyltrichlorsilan, etwa 1,1 g Aminopropyltrimethoxysilan, etwa 1,0 g Piperidin und etwa 20,5 g Toluol enthält, wird in einem Tauchbeschichtungsverfahren auf eine Keramikunterlage zu einer Nassschichtdicke von etwa 30 µm aufgetragen. Die Keramikunterlage hat eine Oberflächenrauhigkeit oder einen Mittelwert der Mittellinie von etwa 28 bis 34 µm. Die beschichtete Unterlage wird dann in einen Ofen gebracht und etwa 90 min lang bei etwa 100° C getrocknet. Die getrocknete und beschichtete Keramikunterlage wird in einen Ofen gebracht und in Umgebungsatmosphäre etwa 4 h lang einer erhöhten Temperatur von etwa 700 bis 1000° C ausgesetzt. Die Keramikunterlage hat eine Oberflächenrauhigkeit von nur 14 bis 18 µm (Mittelwert der Mittellinie) und das resultierende Zersetzungsprodukt der Organosiliciumverbindung ist ein glasartiges Material. Während des Beschichtens wurde beobachtet, dass der Film einheitlich auf der gesamten Substratoberfläche fliesst. Das oben angegebene Beschichtungsverfahren wie auch das Trocknen und die Zersetzungsschritte werden erneut angewendet unter Erhalt einer Keramikunterlage nach dieser zweiten Beschichtung mit einer Oberflächenrauhigkeit von nur 5 bis 11 µm (Mittelwert der Mittellinie).

*Beispiel 2:*

Beispiel 1 wird wiederholt mit der Ausnahme, dass die Zusammensetzung etwa 1,8 g β-(3,4-Epoxidcyclohexyl)äthyltrimethoxysilan, etwa 1,0 g Vinyltriäthoxysilan, etwa 0,7 g Vinyltriacetoxysilan, etwa 1,0 g Piperidin und etwa 20,5 g Toluol enthält. Es werden ähnliche Ergebnisse wie in Beispiel 1 erhalten.

*Beispiel 3:*

Beispiel 1 wird wiederholt mit der Ausnahme, dass die Beschichtungszusammensetzung etwa 1,8 g β-(3,4-Epoxidcyclohexyl)äthyltrimethoxysilan, etwa 1,2 g Vinyl-tris(2-methoxyäthoxy)-silan, etwa 0,5 g Vinyltriacetoxysilan, etwa 1,0 g Piperidin und etwa 20,5 g Toluol enthält. Es werden ähnliche Ergebnisse wie in Beispiel 1 erhalten.

*Beispiel 4:* (Vergleichsbeispiel)

Beispiel 1 wird wiederholt mit der Ausnahme, dass die Beschichtungszusammensetzung etwa 1,8 g β-(3,4-Epoxidcyclohexyl)äthyltrimethoxysilan, etwa 1,7 g Aminopropyltrimethoxysilan, etwa 1,0 g Piperidin und etwa 20,5 g Toluol enthält. Es werden ähnliche Ergebnisse wie in Beispiel 1 erhalten, jedoch wird die Oberflächenrauhigkeit nicht in dem Masse wie in den Beispielen 1 bis 3 herabgesetzt. In diesem Beispiel wurden keine ungesättigten Silane verwendet und demzufolge findet ein Vernetzen und eine Gel-Bildung von Silanverbindungen wie in den Beispielen 1 bis 3 nicht statt. Durch das Vernetzen und die Gel-Bildung wird in den Beispielen 1 bis 3 verglichen mit Beispiel 4 eine einheitlichere und grössere Beschichtungsdicke erhalten, wodurch wiederum dickere Siliciumoxidschichten und eine grössere Oberflächenverbesserung nach der Hochtemperaturzersetzung erhalten werden.

## Patentansprüche

1. Verfahren zur Herabsetzung der Porosität und der Oberflächenrauhigkeit einer keramischen Unterlage, dadurch gekennzeichnet, dass eine flüssige Beschichtungszusammensetzung mit einem Gehalt an wenigstens einer nichtpolymeren gesättigten organischen Siliciumverbindung und wenigstens einer nichtpolymeren äthylenisch ungesättigten organischen Siliciumverbindung auf wenigstens eine Oberfläche der Unterlage aufgetragen wird, die beschichtete Unterlage getrocknet und zur Umwandlung der Organosiliciumverbindungen in Siliciumoxide einer Temperatur ausgesetzt wird, die höher als die bei der Trocknung angewendete ist.

2. Verfahren nach Anspruch 2, dadurch gekennzeichnet, dass eine Beschichtungszusammensetzung mit einem Gehalt an 45 bis 95 Gew.% einer nichtpolymeren gesättigten organischen Siliciumverbindung und 5 bis 55 Gew.% einer nichtpolymeren äthylenisch ungesättigten organischen Siliciumverbindung, bezogen auf den Gesamtgehalt an gesättigten und ungesättigten organischen Siliciumverbindungen, angewendet wird.

3. Verfahren nach Anspruch 1, dadurch gekennzeichnet, dass als Unterlage ein Keramikmaterial aus Siliciumoxid, Silicat und Aluminiumoxid angewendet wird.

4. Verfahren nach den Ansprüchen 1 und 2, dadurch gekennzeichnet, dass eine Beschichtungszusammensetzung, die β-(3,4-Epoxidcyclohexyl)äthyltrimethoxysilan und eine äthylenisch ungesättigte organische Siliciumverbindung aus der Gruppe von Vinyltrichlorsilan, Vinyltriäthoxysilan, Vinyl-tris-(2-methoxyäthoxy)silan, Vinyltriacetoxysilan und Mischungen derselben enthält, angewendet wird.

5. Verfahren nach den Ansprüchen 1, 2 und 4, dadurch gekennzeichnet, dass eine Beschichtungszusammensetzung, die zusätzlich Aminopropyltriäthoxysilan enthält, angewendet wird.

6. Verfahren nach einem oder mehreren der Ansprüche 1 bis 5, dadurch gekennzeichnet, dass eine Beschichtungszusammensetzung, die zusätzlich ein organisches Lösungsmittel und einen Stabilisator enthält, angewendet wird.

7. Verfahren nach Anspruch 6, dadurch gekennzeichnet, dass eine Beschichtungszusammensetzung, die das Verdünnungsmittel in einer Menge von 25 bis 90 Gew.%, bezogen auf den Gesamtgehalt an Lösungsmittel und Siliciumverbindungen in der Zusammensetzung enthält, angewendet wird.

8. Verfahren nach Anspruch 6, dadurch gekennzeichnet, dass eine Zusammensetzung, die einen Stabilisator in einer Menge von 2,5 bis 7 Gew.%, bezogen auf den Gesamtgehalt an organischer Siliciumverbindung, Verdünnungsmittel und Stabilisator enthält, angewendet wird.

9. Verfahren nach Anspruch 1, dadurch gekennzeichnet, dass die Beschichtungszusammensetzung in einem Beschichtungsschritt in einer Nassschichtdicke bis zu 0,1 mm aufgetragen wird.

10. Verfahren nach den Ansprüchen 1 und 9, dadurch gekennzeichnet, dass ein Mehrfachbeschichtungsverfahren angewendet wird.

11. Verfahren nach Anspruch 1, dadurch gekennzeichnet, dass die beschichtete Unterlage 30 min bis 2 h lang bei einer Temperatur von 50 bis 200° C getrocknet wird.

12. Verfahren nach Anspruch 1, dadurch gekennzeichnet, dass die getrocknete beschichtete Unterlage 2 bis 6 h lang auf 500 bis 1700° C, vorzugsweise 700 bis 1300° C erhitzt wird.

13. Verfahren nach den Ansprüchen 1 und 12, dadurch gekennzeichnet, dass das Erhitzen in Gegenwart von Luft durchgeführt wird.

14. Beschichtungszusammensetzung zur Durchführung des Verfahrens nach den Ansprüchen 1 bis 13, gekennzeichnet durch einen Gehalt an 45 bis 95 Gew.% einer gesättigten organischen Siliciumverbindung aus der Gruppe von β-(3,4-Epoxidcyclohexyl)äthyltrimethoxysilan und Mischungen derselben mit Aminopropyltrimethoxysilan und 5 bis 55 Gew.% einer ungesättigten organischen Siliciumverbindung aus der Gruppe von Vinyltrichlorsilan, Vinyltriäthoxysilan, Vinyl-tris-(2-methoxyäthoxy)silan, Vinyltriacetoxysilan und Mischungen derselben, wobei die Gew.% bezogen sind auf den Gesamtgehalt an gesättigten und ungesättigten organischen Siliciumverbindungen in der Zusammensetzung.

15. Verwendung der Beschichtungszusammensetzung nach Anspruch 14 zur Herabsetzung der Porosität und der Oberflächenrauhigkeit einer keramischen Unterlage für metallische Schaltkreise.

## Claims

1. Method for reducing the porosity and surface roughness of a ceramic substrate, characterized in that a liquid coating composition containing at least one nonpolymeric saturated organosilicon compound, and at least one nonpolymeric, ethylenically unsaturated organosilicon compound is applied on at least one surface of the substrate, that the coated substrate is dried, and for converting the organosilicon compounds into silicon oxides the coated substrate is exposed to a temperature which is higher than that used for drying.

2. Method as claimed in claim 2, characterized in that a coating composition containing 45 to 95% by weight of a nonpolymeric saturated organosilicon compound, and 5 to 55% by weight of a nonpolymeric, ethylenically unsaturated organosilicon compound, based on the total of saturated and unsaturated organosilicon compounds is used.

3. Method as claimed in claim 1, characterized in that a ceramic material of silicon oxide, silicate, and aluminium oxide is used as a substrate.

4. Method as claimed in claims 1 and 2, characterized in that a coating composition containing β-(3,4-epoxycyclohexyl)ethyltrimethoxysilane and an ethylenically unsaturated organosilicon compound of the group containing vinyltrichlorosilane, vinyltriethoxysilane, vinyltris-(2-methoxyethoxy)silane, vinyltriacetoxysilane, and mixtures thereof is used.

5. Method as claimed in any one of claims 1, 2, and 4, characterized in that a coating composition is used which additionally contains aminopropyltrimethoxysilane.

6. Method as claimed in one or several of claims 1 to 5, characterized in that a coating composition is used which also contains an organic solvent and a stabilizer.

7. Method as claimed in claim 6, characterized in that a coating composition is used which contains the diluent in amounts of 25 to 90% by weight, based on the total of solvent and silicon compounds in the composition.

8. Method as claimed in claim 6, characterized in that a composition is used which contains a stabilizer in an amount of 2.5 to 7% by weight, based on the total of organosilicon compound, diluent and stabilizer.

9. Method as claimed in claim 1, characterized in that the coating composition is applied in one coating step in a wet thickness of up to 0.1 mm.

10. Method as claimed in any one of claims 1 to

9, characterized in that a multiple coating method is applied.

11. Method as claimed in claim 1, characterized in that the coated substrate is dried for 30 min up to 2 h at a temperature of 50 to 200° C.

12. Method as claimed in claim 1, characterized in that the dried coated substrate is heated for 2 to 6 h, to 500 to 1700° C, preferably 700 to 1300° C.

13. Method as claimed in any one of claims 1 to 12, characterized in that heating is conducted in the presence of air.

14. Coating composition for applying the method as claimed in any one of claims 1 to 13, characterized by contents of 45 to 95% by weight of a saturated organosilicon compound selected from the group containing β-(3,4-epoxycyclohexyl)ethyltrimethoxysilane, and mixtures thereof with aminopropyltrimethoxysilane, and 5 to 55% by weight of an unsaturated organosilicon compound selected from the group of vinyltrichlorosilane, vinyltriethoxysilane, vinyltris(2-methoxyethoxy)silane, vinyltriacetoxysilane and mixtures thereof, the percents by weight referring to the total of saturated and unsaturated organosilicon compounds in the composition.

15. Use of the coating composition as claimed in claim 14 to reduce the porosity and the surface roughness of a ceramic substrate for metallic circuitry.

## Revendications

1. Procédé pour réduire la porosité et la rugosité de la surface d'un support en céramique, caractérisé en ce qu'on dépose, sur au moins une surface du support, une composition de revêtement liquide contenant au moins un composé organosilicique saturé, non polymère, et au moins un composé organosilicique, non polymère, éthylénique non saturé, et en ce qu'on sèche le support ainsi revêtu qui est ensuite soumis à une température supérieure à celle utilisée pour le séchage pour transformer les composés organosiliciques en oxydes de silicium.

2. Procédé selon la revendication 2, caractérisé en ce qu'on utilise une composition de revêtement contenant de 45 à 95% en poids d'un composé organosilicique saturé, non polymère, et de 5 à 55% en poids d'un composé organosilicique non polymère, ethylénique non saturé, par rapport au contenu total en composés organosiliciques non saturés et saturés.

3. Procédé selon la revendication 1, caractérisé en ce qu'on utilise comme support un matériau en céramique constitué d'oxyde de silicium, de silicate et d'oxyde d'aluminium.

4. Procédé selon les revendications 1 et 2, caractérisé en ce qu'on utilise une composition de revêtement contenant du β-(3,4-époxycyclohexyle)éthyletriméthoxysilane et un composé organosilicique éthylénique, non saturé, choisi dans le groupe comprenant le vinyltrichlorosilane, le vinyltriéthoxysilane, le vinyltris(2-méthoxyéthoxy)silane, le vinyltriacétoxysilane et les mélanges de ceux-ci.

5. Procédé selon les revendications 1, 2 et 4, caractérisé en ce qu'on utilise une composition de revêtement qui contient en outre de l'aminopropyletriméthoxysilane.

6. Procédé selon l'une ou plusieurs des revendications 1 à 5, caractérisé en ce qu'on utilise une composition de revêtement contenant en outre un solvant organique et un stabilisateur.

7. Procédé selon la revendication 6, caractérisé en ce qu'on utilise une composition de revêtement contenant le solvant dans une proportion de 25 à 90% en poids par rapport au contenu total en solvant et en composé de silicium, dans la composition.

8. Procédé selon la revendication 6, caractérisé en ce qu'on utilise une composition contenant un stabilisateur dans une proportion de 2,5 à 7% en poids par rapport au contenu total en composé organosilicique, en solvant et en stabilisateur.

9. Procédé selon la revendication 1, caractérisé en ce qu'on dépose la composition de revêtement, lors d'une étape de dépôt, sur une épaisseur de couche humide jusqu'à 0,1 mm.

10. Procédé selon les revendications 1 à 9, caractérisé en ce qu'on utilise un procédé de dépôts multiples.

11. Procédé selon la revendication 1, caractérisé en ce qu'on sèche la couche revêtue pendant une période allant de 30 min à 2 h à une température comprise entre 50 et 200° C.

12. Procédé selon la revendication 1, caractérisé en ce qu'on chauffe le support revêtu et séché de 2 à 6 h à une température comprise entre 500 et 1700° C, de préférence entre 700 et 1300° C.

13. Procédé selon l'une quelconque des revendications 1 à 12, caractérisé en ce qu'on chauffe en présence d'air.

14. Composition de revêtement pour exécuter le procédé selon les revendications 1 à 13, caractérisée en ce qu'elle contient de 45 à 95% en poids d'un composé organosilicique saturé choisi dans le groupe constitué de β-(3,4-époxycyclohexyle)éthyltriméthoxysilane, et des mélanges de celui-ci avec de l'aminopropyltriméthoxysilane, et de 5 à 55% en poids d'un composé organosilicique non saturé choisi dans le groupe constitué de vinyltrichlorosilane, de vinyltriéthoxysilane, de vinyltris-(2-méthoxyéthoxy)silane, de vinyltriacétoxysilane et des mélanges de ceux-ci, les pourcentages en poids se rapportant au contenu total en composés organosiliciques non saturés et saturés dans la composition.

15. Utilisation de la composition de revêtement selon la revendication 14, pour réduire la porosité et la rugosité de surface d'un support en céramique pour des circuits métalliques.